# EUROPEAN PATENT APPLICATION

(11) **EP 4 520 851 A1**
(43) Date of publication of application: **12.03.2025**
(21) Application number: 23195798.6
(22) Date of filing: 06.09.2023
(51) Int. Cl.: C23C 14/02, C23C 14/24, C23C 14/50, G02B 1/14, C23C 14/56, B29D 11/00, C23C 2/00, G02B 1/10, G02B 7/02, B05C 13/00, B05D 1/18

(54) **MOUNTING FRAME AND METHOD FOR COATING A SPECTALE LENS PRODUCT**

(71) Applicant: Carl Zeiss Vision International GmbH, 73430 Aalen (DE)
(72) Inventor: FRIEDL, Alexander, 73434 Aalen (DE); KOENEN, Timo, 73566 Bartholomä (DE); KOEPPEL, Julia, 73479 Ellwangen (DE); KUMAR, Ankit, 73430 Aalen (DE); SCHAMBECK, Andreas, 73431 Aalen (DE); VOLK, Kirsten, 73447 Oberkochen (DE); MACIONCZYK, Frank, 73447 Oberkochen (DE)
(74) Representative: Tautz & Schuhmacher

(57) **Abstract**

Provided is a mounting frame (10) suitable for mounting a spectacle lens product (12) in a coating process. The mounting frame (10) comprises a frame element (14) adapted to surround at least partially a circumferential edge (12a) of the spectacle lens product (12) when mounted in the mounting frame (10), and a mechanical clamp element (16) adapted to mechanically fixate a mounting extension (18) of the spectacle lens product to the frame element (10), when the spectacle lens product (12) is mounted in the mounting frame (10). The mounting frame (10) is characterized in that the frame element (14) is made of a heat-sustainable polymeric material sustaining a temperature of at least 120° C.

## Description

Provided are a mounting frame suitable for mounting a spectacle lens product in a coating process, a method for coating a spectacle lens product, and a method for manufacturing a finished spectacle lens product. The disclosure is, thus, related to manufacturing spectacle lens products.

Typically, various coatings are applied to spectacle lens products during the process of manufacturing spectacle lenses. While some coatings, such as a hard coating, may be applied by dip coating the spectacle lens product, other coatings, such as an anti-reflection coating, AR coatings, may be applied by evaporation processes in vacuum. Different mounting elements are conventionally used during the coating processes. This often requires transferring the spectacle lens products between different coating steps from one kind of a mounting element to a different kind of mounting element, as none of the conventionally known mounting elements is usable for all coating processes carried out during the manufacturing of a spectacle lens or a spectacle lens finished product. A mounting element for dip coating often is required to sustain dip coating, as it may be dipped into a coating bath alongside a spectacle lens product mounted therein. When reusing the mounting frame after the coating process of the spectacle lens product is intended, it may be required to provide the mounting element from a material sustaining the conditions during dip coating and removing the coating layers after the coating process is completed. In contrast, a mounting element suitable for mounting a spectacle lens product during a coating process involving an evaporation coating process in vacuum may be required to sustain vacuum conditions and may be required to refrain from degassing under vacuum conditions. Hence, the requirements for different kinds of mounting elements for different coating steps may vary significantly.

Conventionally, when coating a spectacle lens product, a hard coating is applied to the spectacle lens as part of a first coating step, which may include dip coating the spectacle lens product and annealing the applied hard coating by subjecting the coated spectacle lens product to heat. In a further coating process, an AR coating is typically applied to the spectacle lens product. For this purpose, the spectacle lens product is conventionally removed from the mounting element fixating the spectacle lens product during the hard coating process, which may involve manually breaking or cutting the spectacle lens product from the mounting element used for dip coating. Other conventional techniques may involve mechanically fixating the spectacle lens product using one or more spring-loaded clamps during the dip coating process. During this separation, splinters of the hard coating may chip off, which in some cases may stick to a surface of the spectacle lens product and may impair the further coating process(es). Significant adhesive forces between such splinters and the surface of the spectacle lens product may impair the removal of such splinters from the spectacle lens product and, hence, may render the spectacle lens product unfit for any further use. Conventionally, such splinters arising from a separation of the spectacle lens product from a mounting element used during hard coating cause a reject rate in the range of 1% to 2% of all coated spectacle lens products. Moreover, separating the spectacle lens product from the mounting element after hard coating may result in damages of the coated spectacle lens product, which may further increase the reject rate during the coating process(es).

For instance, the document JPH07234301A describes a lens holder for dip coating an optical lens. Moreover, DE102006041137A1 describes a mounting element for mounting a spectacle lens product at a calotte shaped substrate holder in a vacuum coating device such that the spectacle lens can be flipped with respect to the calotte shaped substrate holder.

The problem to be solved, thus, relates to providing a mounting element and a method for coating a spectacle lens product.

In view of DE102006041137A1, which may be considered as closest prior art, the objective technical problem of the claimed subject-matter may be considered as providing a mounting element and a method for coating a spectacle lens product suitable to enrich the prior art. The objective technical problem may optionally relate to providing a mounting element and a method for coating a spectacle lens product suitable to facilitate the coating of a spectacle lens product.

This problem is solved by a mounting frame, a method for coating a spectacle lens product and a method for manufacturing a finished spectacle lens product having the features of the respective independent claims. Optional embodiments are provided in the dependent claims and the description.

In a first aspect, a mounting frame suitable for mounting a spectacle lens product in a coating process is provided. The mounting frame comprises a frame element adapted to surround at least partially a circumferential edge of the spectacle lens product when mounted in the mounting frame. Furthermore, the mounting frame comprises a mechanical clamp element adapted to mechanically fixate a mounting extension of the spectacle lens product to the frame element when the spectacle lens product is mounted in the mounting frame. The mounting frame is characterized in that the frame element is made of a heat-sustainable polymeric material sustaining a temperature of at least 120° C. "Surrounding at least partially" may mean that not the entire circumferential edge of the spectacle lens is contact with the frame element but only a part of the circumferential edge, such as optionally half or three quarters of the circumferential edge.

In another aspect, a method for coating a spectacle lens product is provided. The method comprises providing the spectacle lens product mounted in a mounting frame, wherein the spectacle lens product is connected to the mounting frame at a connection point at a circumferential edge of the spectacle lens product, and applying a hard coating to the spectacle lens product, including dip coating the spectacle lens product while the spectacle lens product is mounted in the mounting frame. The method further comprises applying an anti-reflection coating, AR coating, to the spectacle lens product while the spectacle lens product is mounted in the mounting frame.

In yet another aspect, a method for manufacturing a finished spectacle lens product from a spectacle lens product is provided, wherein the method comprises coating the spectacle lens product using a method according to the disclosure.

A mounting frame may be an element for holding a spectacle lens product during one or more coating processes. The mounting frame may be adjusted such that at least one surface of a spectacle lens product to be coated, which is mounted in the mounting frame, may be accessible for the coating process. The mounting frame may be adjusted to contact the spectacle lens product at a peripheral edge of the spectacle lens product. The mounting frame may be adjusted, such that the mounting frame may sustain a coating process to which a mounted spectacle lens product is subjected. Moreover, the mounting frame may be reusable to sequentially mount multiple spectacle lens products to be coated. The mounting frame may be adjusted to allow reversing at least partially an alteration of the mounting frame occurring during one or more coating processes at least partially.

A frame element may be an element of the mounting frame, which may at least partially surround a circumferential edge of a mounted spectacle lens product. The frame element may be adjusted to stabilize the mounting frame and/or to provide rigidity to the mounting frame. Alternatively or additionally, the mounting frame may be adjusted to protect a circumferential edge of the spectacle lens product when mounted in the mounting frame.

A mechanical clamp element may be a mechanical element suitable for mechanically fixating a mounting extension of the spectacle lens product to the frame element by mechanical force. The mechanical clamp element may be adjusted to fixate the mounting extension in a force-fitted manner.

The polymeric material being heat-sustainable means that the frame element being made of said heat-sustainable material maintains its function when and after being exposed to temperatures of up to 120°C and optionally to even higher temperatures, such as for example temperatures of up to 140° C or more and/or up to 160°C or more. Optionally the polymeric material may be adapted to sustain temperatures of up to 130°C or up to 160 C or up to 180 C. The frame element may be adapted to maintain its shape and/or rigidity when exposed to temperatures of up to 120°C or more. Maintaining its shape and/or rigidity means that no alteration of the shape and/or rigidity occurs or that a possibly occurring alteration of the shape and/rigidity does not impair the function of the mounting frame. Moreover, the polymeric material may be chosen to be suitable for applications under high vacuum conditions, which may include being exposed to pressures in a range from 10⁻⁵ to 10⁻⁷ mbar. The polymeric material may exhibit a lower degassing rate than may other conventional polymeric materials conventionally used in dip coating applications but not exposed to high vacuum conditions.

A spectacle lens product may be one of a spectacle lens, a lens blank, and a semi-finished lens blank. The spectacle lens blank may be a precursor of a finished spectacle lens product and/or of a spectacle lens. The spectacle lens may be made by edging a finished lens to the shape and dimension of a predetermined spectacle frame, into which the spectacle lens is to be inserted.

A lens blank may relate to an unprocessed precursor of a spectacle lens, such as a lens blank having an unprocessed front surface and an unprocessed back surface. The lens blank may be provided in a molding process. The lens blank may, however, also relate to a partly processed precursor of a spectacle lens. For instance, the lens blank may have a front surface which is partly or fully processed, and which may be covered with a protective foil or coating. As generally understood and defined in section 3.8.1 of ISO 13666:2019 (E), a lens blank may be a piece of optical material with one optically finished surface for the making of a lens. A semi-finished lens blank may have an optically finished surface.

A finished lens may be understood as a lens of which both sides have their final optical surface, as defined in section 3.8.7 of ISO 13666:2019 (E). One or more coating processes may transform the spectacle lens product, which may be a lens blank or a semi-finished lens blank, into a finished lens.

As generally understood and defined in section 3.5.2 of ISO 13666:2019 (E), a spectacle lens may be an ophthalmic lens according to section 3.5.1 of ISO 13666:2019 (E) worn in front of, but not in contact with, the eyeball.

The disclosure provides the advantage that a spectacle lens product may be kept mounted in one and the same mounting frame during a hard coating process as well as during an AR coating process. This facilitates the coating process, as no change of the mounting frame is needed between the different coating processes.

This allows eliminating possible risks of impairing the spectacle lens products due to damages that may conventionally arise when separating the spectacle lens product from a mounting frame and/or when mounting the spectacle lens product into a different mounting frame. In particular, the disclosure may provide the advantage that no splinters of hard coating pose a risk of impairing the spectacle lens product, as no separating of the spectacle lens product from the mounting frame is required prior to the AR coating process.

In addition, the disclosure provides the advantage that the coating process and, hence, a manufacturing process for a finished lens, may be facilitated and/or an efficiency may be increased, as less manual working steps are required. As the mounting frame may be used for mounting the spectacle lens product during the hard coating process as well as during the AR coating process, no change of mounting frames is required between the coating steps and, thus, the effort for such a change of mounting frames may be omitted. Consequently, the disclosure provides the advantage that the effort and costs of a coating process and a manufacturing of a finished lens and a spectacle lens may be reduced.

Moreover, the disclosure provides the advantage that a mounting frame is provided which may be reusable in multiple coating processes, wherein each coating process may include a hard coating and an AR coating process. Due to the frame element being made of a heat-sustainable polymeric material, the mounting frame may well sustain an optional annealing step for curing the hard coating, during which the mounting frame may be exposed to a temperature of up to 100° C or more. The annealing step may be carried out by heating the spectacle lens product mounted in the mounting frame in a pass-through oven. In addition, the frame element being made of a polymeric material may facilitate removing the hard coating from the frame element or the entire mounting frame prior to using the mounting frame for mounting the next spectacle lens product to be treated in hard coating and AR coating processes.

The mounting frame may further comprise a magnetic element arranged at a first section of the frame element, wherein the magnetic element is adapted to allow flipping the mounting frame around a flipping axis by applying a magnetic force to the magnetic element. This may allow to automatedly flip the mounting frame around the flipping axis. This may provide the further advantage that no manual flipping may be required and, hence, the automated flipping may be carried out inside a vacuum chamber without a need of venting the vacuum chamber. Accordingly, this may allow applying an AR coating on a back surface and a front surface in two consecutive coating processes, wherein said two consecutive coating processes may be carried out in the vacuum chamber without requiring venting and opening the vacuum chamber between the coating processes. The automated flipping may be induced by applying a magnetic force to the magnetic element resulting in a flipping movement of the mounting frame and a spectacle lens product mounted therein. Alternatively or additionally, the magnetic element may serve the purpose of attaching the mounting frame to a carrier element for transporting and/or positioning the mounting frame during a coating process. The mounting frame may be attachable to a carrier element by means of a magnetic force applied to the magnetic element. The mounting frame may be held at the carrier element solely by magnetic force. The carrier element may be adapted to carry multiple mounting frames, wherein each mounting frame may be held at the carrier element by a magnetic force applied to the respective magnetic element of the respective mounting frame. The carrier element may comprise one or more magnetic fixation elements for interacting with the respective magnetic elements of the one or more mounting frames. The magnetic element of the mounting frame may comprise a permanent magnet and/or a ferromagnetic material. The magnetic fixation element of the carrier element may comprise a permanent magnet and/or an electric magnet and/or a ferromagnetic material.

The magnetic element may be made of a magnetic material and/or a magnetizable material. Optionally, the magnetic element may comprise or consist of a ferromagnetic material. This may allow applying a mechanical force to the magnetic element and, hence, to the mounting frame by providing a magnetic force acting on the magnetic element. Thus, according to some embodiments the magnetic element may be provided such as not to provide a magnetic field by itself but to be magnetizable when applying an external magnetic field, such as by a permanent magnet and/or an electromagnet.

The mounting frame may further comprise a counterweight element for balancing a weight distribution of the mounting frame with respect to the flipping axis. This may facilitate the flipping of the mounting frame. In particular, this may reduce a required force to be applied for inducing the flipping of the mounting frame.

Dip coating the spectacle lens product mounted in the mounting frame may comprise (i) attaching the mounting frame to a carrier element by applying a magnetic force to the one or more magnetic elements, and (ii) moving the carrier element with the aim of dipping the spectacle lens product mounted in the mounting frame into a lacquer bath. Alternatively or additionally, the lacquer bath may be moved with respect to the carrier element.

During the dip coating process the mounting frame may be inserted in a lacquer bath such that a part of the frame element and a spectacle lens product mounted in the frame element are covered by the lacquer bath while the magnetic element attached to a carrier element remain outside of the lacquer bath. This may provide the advantage that the magnetic element and the carrier element are not covered with lacquer from the lacquer bath for hard coating, but instead remain uncoated. This may prevent a potential degradation of the magnetic element and the carrier element due to undesired contact with lacquer.

The mechanical clamp element may be arranged at a second half of the frame element opposing a first half of the frame element including the first section of the frame element including the magnetic element. The flipping axis may extend at an imaginary axis imaginarily separating the first half of the frame element and the second half of the frame element. The mechanical clamp element and/or the counterweight element may be arranged in a second section of the frame element, which may be arranged in a symmetric manner with respect to the flipping axis. The mechanical clamp element arranged at the second half of the frame element may provide the advantage that it would be located at a lower end of the frame element when the magnetic element is arranged at an upper end of the frame element. This provides the advantage that a flow of lacquer draining from the mechanical clam element and/or a mounting extension fixated by the mechanical clamp element over the spectacle lens product when removing the mounting frame from the lacquer bath may be prevented. Consequently, undesired irregularity in the thickness of the hard coating applied by dip coating may be avoided.

The mounting frame may further comprise multiple bearing protrusions arranged at opposing sides of the frame element and extending along the flipping axis. This may allow for a support of the mounting frame by the bearing protrusions resting on a suitable support element, which may allow rotating the mounting frame around the flipping axis by rotating the mounting frame around the bearing protrusions.

The polymeric material may comprise or consist of polyoxymethylene. This may provide a suitable rigidity and/or stability of the frame element while providing the heat-sustainability for temperatures of at least 120° C. Moreover, the mounting frame being made of or comprising polyoxymethylene may facilitate the removal of a hard coating applied during a dip coating process prior to using the mounting frame for mounting a subsequent spectacle lens product. The adhesive force of a hard coating applied to a frame element made of or comprising polyoxymethylene may be weaker than that of a hard coating applied to a conventional frame element made of metal, such as aluminum or stainless steel. Moreover, polyoxymethylene is suitable for applications under high vacuum conditions, which may include being exposed to pressures in a range from 10⁻⁵ to 10⁻⁷ mbar. The polymeric material polyoxymethylene exhibits a low degassing rate and, thus, bears no or only a negligible risk of contaminating the vacuum due to degassing.

Dip coating the spectacle lens product mounted in the mounting frame may include dip coating the mounting frame at least partially. In other words, when dip coating the spectacle lens product, the mounting frame may be at least partially immersed into the lacquer bath with the spectacle lens product. The mounting frame may be immersed into the lacquer bath such that the entire spectacle lens product mounted in the mounting frame is immersed into the lacquer bath for dip coating. The dip coating may be carried out such that the optional magnetic element of the mounting frame and a carrier element to which the mounting frame is attached by means of the magnetic element is not immersed into the lacquer bath. This may provide the advantage that no hard coating is applied to the magnetic element and the carrier element and, thus, no removal of a hard coating from these components is required.

Applying the AR coating to the spectacle lens product includes arranging the spectacle lens product mounted in the mounting frame in a vacuum chamber. Applying the AR coating may further comprise evacuating the vacuum chamber with the spectacle lens product and the mounting frame arranged in the vacuum chamber. In other words, applying the AR coating to the spectacle lens may include inserting the spectacle lens product in the vacuum chamber while still being mounted in the very same mounting frame used for hard coating the spectacle lens product. This provides the advantage that no separation of the spectacle lens product from the mounting frame after the hard coating process and prior to the AR coating process is required. Instead, such a step of separating the hard coated spectacle lens product prior to the AR coating process can be omitted and a possible impairment of the hard coating or the spectacle lens product by splinters of hard coating, which conventionally may occur in such a separation step, prior to the AR coating process can be prevented.

Applying the AR coating to the spectacle lens product may comprise (i) applying the AR coating to a first surface of the spectacle lens product, (ii) flipping the mounting frame with the spectacle lens product mounted therein around a flipping axis of the mounting frame, (iii) and applying the AR coating to a second surface of the spectacle lens product. This provides the advantage that an AR coating may be applied on two surfaces of the spectacle lens product, e. g. on a front surface and a back surface of the spectacle lens product. Optionally, a clean coating may be applied to one or more surfaces of the spectacle lens product. The clean coating may be a coating reducing and/or avoiding an adhesion of contaminants to the spectacle lens product. The clean coating may be adjusted to provide anti-adhesive properties similar to a lotus effect. The clean coating may be applied by an evaporation process in the vacuum chamber. Accordingly, the clean coating may be applied after finishing the application of the AR coating. Optionally, when the spectacle lens product is mounted in the vacuum chamber, the AR coating may be applied to a first surface of the spectacle lens product. Afterwards, the spectacle lens product may be flipped and the AR coating and a clean coating may be applied to the second surface of the spectacle lens product. Afterwards, the spectacle lens product may be flipped again to apply the clean coating to the first surface. This may allow reducing the number of changes of the evaporation source to only one change from materials for the AR coating to the material or materials for the clean coating.

The AR coating may be provided at least partly with anti-static properties. In particular, one or more layers of the AR coating may be provided with electrically conductive properties, such as indium tin oxide. This may avoid static electric charges at the surface of the spectacle lens product, which otherwise could attract dust and/or other contaminants. Hence, the antistatic properties may facilitate the cleaning of the spectacle lens product and/or facilitate keeping the spectacle lens product clean. The anti-static coating may prevent the spectacle lens product from becoming electrically charged . The anti-static coating may comprise or consist of a coating with indium-tin-oxide (ITO). The anti-static coating may form a layer within a multi-layer structure forming the AR coating.

Flipping the mounting frame around the flipping axis of the mounting frame may be carried out inside the evacuated vacuum chamber. In particular, flipping the mounting frame around the flipping axis may be carried out in the evacuated vacuum chamber, i. e. without venting the vacuum chamber. This allows coating two surfaces of the spectacle lens product with an AR coating without a need of venting the vacuum chamber between coating the first and the second surface of the spectacle lens product. This provides the advantage of facilitating the AR coating process and reducing the required time and effort for coating both surfaces of the spectacle lens product.

The mounting frame may comprise one or more magnetic elements, wherein flipping the mounting frame may be carried out at least partially by applying a magnetic force to the one or more magnetic elements. This may allow an automated flipping of the mounting frame thus manually flipping the mounting frame may be avoided. In particular, this may allow an automated flipping of the mounting frame inside the evacuated vacuum chamber, as no need for manual interaction with the mounting frame may be required.

The spectacle lens product may be mounted in the mounting frame such that (i) a mounting extension is attached to the spectacle lens product, and (ii) the mounting extension is fixated to the mounting frame. Attaching the mounting extension to the spectacle lens product may comprise attaching the mounting extension to the spectacle lens product at least partly by an adhesive. This may allow refraining from directly applying a mechanical force to the spectacle lens product, such as usually applied by a clamp element. The mounting extension may be made of or comprise polycarbonate. The mounting extension may be adapted to sustain the conditions occurring during the hard coating and the AR coating process. As the mounting extension may be provided with significantly smaller dimensions and amounts of material as the frame element, its properties regarding a use in vacuum during the AR coating process may be less critical than for the mounting frame. Even if a material may be chosen for the mounting extension which may degas to some extent under vacuum conditions, the amount of degassing may be irrelevant for the vacuum and/or the AR coating process due to optionally small amounts of material of the mounting extension.

The mounting extension may be mechanically fixated to the mounting frame by one or more clamp elements. This allows the use of mechanical force, such as clamping, to attach the spectacle lens product by means of a mounting extension to the mounting frame and, hence, allows refraining from applying an adhesive to the mounting frame. This may be beneficial as no such adhesive needs to be removed from the mounting frame after separating the spectacle lens product from the mounting frame. Accordingly, this may be beneficial in terms of reusability of the mounting frame. Moreover, this may reduce the effort and required time for fixating the spectacle lens product or the mounting extension to the mounting frame.

The method may further comprise separating the spectacle lens product from the mounting frame after completing applying the hard coating and the AR coating to the spectacle lens product. This may be the only separating step of the spectacle lens from the mounting frame, as no separation and re-mounting may be required between the hard coating process and the AR coating process.

The method for coating a spectacle lens product according to the disclosure may include using a mounting frame according to the disclosure.

The frame element may have a circular or a elliptical or a polygonal shape. In case of a circular shape, the frame element may have a diameter in a range from about 40 mm to 120 mm, and optionally in a range from 50 mm to 100 mm. For different sizes of spectacle lens products, mounting frames of different sizes may be provided. For instance, one kind of mounting frames may have a diameter of 50 mm for mounting small spectacle lens products while a different kind of mounting frames may have a diameter of 100 mm for mounting large spectacle lens products. The diameter may indicate the inner diameter of the opening formed by the frame element.

The mounting frame and optionally the frame element may comprise a coating and/or a structural profile suitable for enhacing a flow off of the lacquer when removing the mounting frame from a lacquer bath during the hard coating process. The coating and/or the profile may be applied to an inner surface and/or an outer surface of the frame element and/or the entire frame element and/or the entire mounting frame. Alternatively or additionally, the frame element may at least partly have a cross-sectional shape enhancing the runoff of the lacquer, wherein the cross-sectional shape may be tapered or bulgy.

It is understood by a person skilled in the art that the features described above, and the features in the following description and figures are not the only features disclosed in the explicitly disclosed embodiments and combinations, but other technically feasible combinations as well as the isolated features are comprised by the disclosure as well. In the following, several optional embodiments and specific examples are described with reference to the figures for illustrating the disclosure without limiting the disclosure to the described embodiments.

Optional embodiments of the disclosure will be illustrated in the following with reference to the drawings. The figures show:
- Figures 1A to 1C: a mounting frame according to an optional embodiment;
- Figure 2A: a structural profile of a frame element according to an optional embodiment;
- Figure 2B: two cross-sectional profiles of a frame element according to optional embodiments;
- Figures 3A and 3B: a carrier element according to an optional embodiment for carrying multiple mounting frames;
- Figure 4: two carrier elements according to another optional embodiment;
- Figure 5: a method for coating a spectacle lens product according to an optional embodiment and a method for manufacturing a finished spectacle lens product.

In the drawings the same reference signs are used for corresponding or similar features in different drawings.

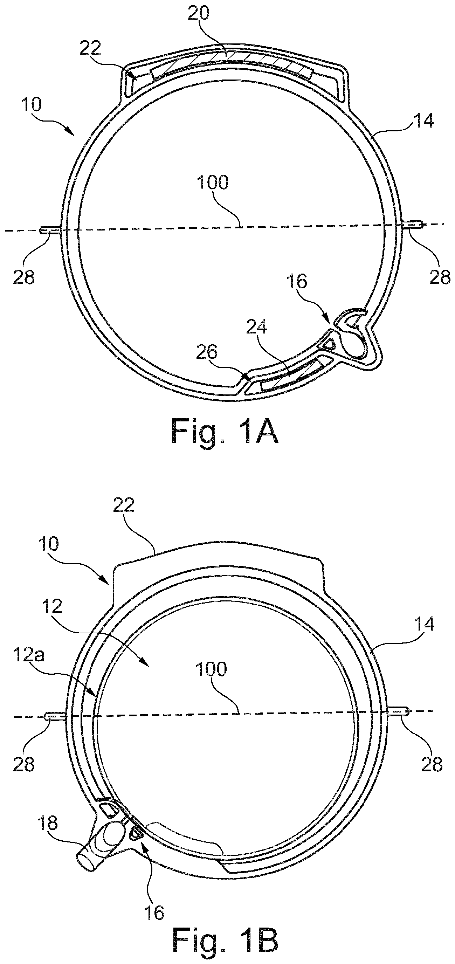

Figures 1A and 1B depict a mounting frame 10 according to an optional embodiment. Figure 1A shows the mounting frame 10 from a back side without a spectacle lens product and Figure 1B shows the mounting frame 10 from a front side with a spectacle lens product 12 mounted in the mounting frame 10. The mounting frame 10 is suitable for mounting a spectacle lens product 12 in a coating process. The mounting frame 10 comprises a frame element 14 adapted to surround at least partially a circumferential edge 12a of the spectacle lens product 12 when mounted in the mounting frame 10. The mounting frame 10 further comprises a mechanical clamp element 16 adapted to mechanically fixate a mounting extension 18 of the spectacle lens product 12 to the frame element 14, when the spectacle lens product 12 is mounted in the mounting frame 10. The frame element 14 is made of a heat-sustainable polymeric material sustaining a temperature of at least 120° C. The polymeric material may comprise or consist of polyoxymethylene.

The mounting frame 10 may further comprise a magnetic element 20 arranged at a first section of the frame element, wherein the magnetic element 20 may be adapted to allow flipping the mounting frame around a flipping axis by 100 applying a magnetic force to the magnetic element 20. The frame element 14 may comprise a void 22 to house the magnetic element 20.

The mounting frame may further comprise a counterweight element 24 for balancing a weight distribution of the mounting frame 10 with respect to the flipping axis 100. The mounting frame may comprise a void 26 to house the counterweight 24.

The mechanical clamp element 16 may be arranged at a second half of the frame element 14 opposing a first half of the frame element 16 including the first section of the frame element 16 including the magnetic element 20.

The mounting frame 10 may further comprise multiple bearing protrusions 28 arranged at opposing sides of the frame element 16 and extending along the flipping axis 100.

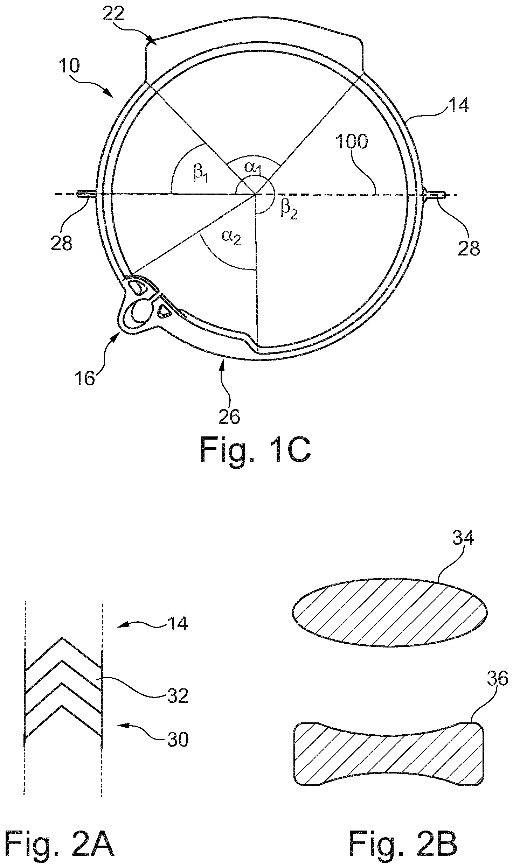

Figure 1C indicates several sections of the mounting frame according to an optional embodiment. The flipping axis 100, which may be defined by the bearing protrusion may form an imaginary border dividing the frame mount into an upper half and a lower half, wherein the upper half comprises the magnetic element 20 and/or the void for the magnetic element 20 and the lower half may comprise the clamping element 16. The void 22 for the magnetic element 20 may extend in a first section defined by the angle *α*₁, which may extend in an angular range from about 40° to 130°. The first section may be centered in the upper half of the mounting frame 10. The angle *β*₁ extends from one end of the void 22 of the magnetic element 20 to the flipping axis 100 and may have a value in an angular range from 5° to 135°. In the lower half of the mounting frame 10, the clamp element 16 and the void 26 for the counterweight 24 may form a unit, which may extend in a second section defined by the angle *α*₂*,* wherein the angle *α*₂ may be in an angular range from 20° to 100°. The angle *β*₂ extending from the right-handed end of the void 26 for the counterweight 24 to the flipping axis may be in the range of 185° to 335° including the 180° angular range of the upper half of the mounting frame 10. This arrangement may result in a suitable weight balancing of the mounting frame 10, which may allow flipping the mounting frame 10 and a spectacle lens product 12 mounted in the mounting frame with low effort. According to other embodiments, the clamp element 16 may be arranged at the frame element separately from the void 26 for the counterweight 24 and may be spaced apart from the void 26 for the counterweight.

Figure 2A schematically depicts a structural profile 30 having recesses 32, which may be applied to the frame element 14, in particular to an inner surface and/or an outer surface of the frame element 14 for enhancing a runoff of the lacquer during a dip coating process.

Figure 2B presents two cross-sectional profiles of the frame element 14 according to optional embodiments, including a bulgy cross-sectional profile 34 and a tapered cross-sectional profile 36.

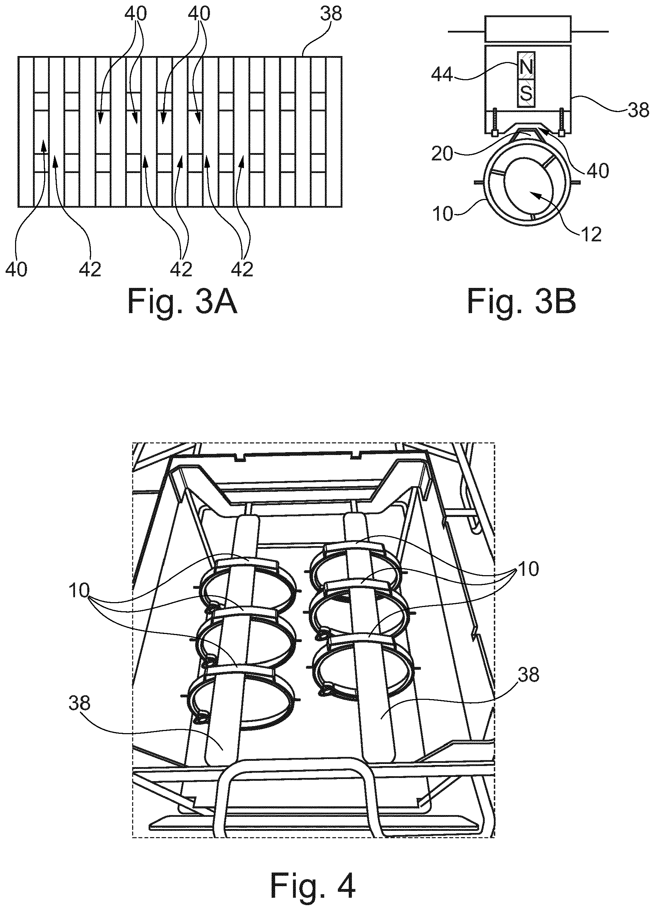

Figures 3A and 3B schematically depict a carrier element 38 according to an optional embodiment for carrying multiple mounting frames 10. Figure 3A presents a schematic bottom view of the carrier element 38 while Figure 3B presents a schematic cross-sectional view of a carrier element 38 having a mounting frame 10 attached thereto. As can be seen in Figure 3A, the carrier element 38 comprises multiple recesses 40 arranged in a parallel manner being separated from each other by respective spacers 42. The recesses 40 allow arranging a mounting frame at an intended location of the carrier element 38, at which a fixation of the mounting frame 10 is intended. The recess 40 may be adapted to the part of the frame element 14 comprising the void 22 of the magnetic element 20 of the mounting frame. The fixation of the mounting frame 10 to the carrier element 38 at the recess 40 may be induced by a magnetic force acting on the magnetic element 20 of the mounting frame. For providing such a magnetic force, the carrier element may comprise one or more magnetic fixation elements 44, which may comprise one or more permanent magnets and/or electric magnets. Optionally, the carrier element may comprise one magnetic fixation element 44 for each recess 40, wherein each recess may define one fixation slot for fixating one mounting frame 10. The magnetic fixation element 44 and/or the magnetic element 20 of the mounting frame may be adapted to provide a magnetic force, which is sufficient for fixating the mounting frame to the carrier element 38 during a dip coating process for hard coating the spectacle lens products 12 mounting in the respective mounting frames 10. However, the magnetic force may be chosen such that it allows an operator to manually remove the mounting frames from the carrier element 38 without modifying or removing the magnetic element 20 and/or the magnetic fixation element 44. Alternatively or additionally, the magnetic fixation element 44 may comprise a controllable electromagnet, which may allow releasing the fixated mounting frames 10 from the carrier element in a controlled and/or automated manner by switching off the respective electromagnet or by reducing a magnetic field strength generated by the respective electromagnet.

The carrier element may be used for carrying multiple mounting frames 10 fixated next to each other at the respective recesses to the carrier element 38 during a dip coating process. For dip coating, the carrier element 38 may approach a lacquer bath such that the mounting frames 10 fixated to the carrier element 38 are immersed into the lacquer bath to entirely immerse the spectacle lens products 12 mounted in the respective mounting frames 12. The dip coating process may be carried out such that magnetic element 20 and/or the part of the frame element 14 housing the magnetic element and/or any part of the carrier element 38 are not put in contact with the lacquer bath. This may prevent contaminations and/or a coverage of the carrier element 38 and/or the magnetic element with hard coating, which, alternatively, may have to be removed in a separate working process.

The magnetic elements 20 and the magnetic fixation elements 44 may be adapted such that a magnetic force applied to the mounting frame for fixating the mounting frame to the carrier element 38 is equal to or exceeds a gravitational force acting on the mounting frame including a mounted spectacle lens product plus possible additional force components, which may arise from various sources, such as vibrations and movements originating in the machine and/or the dip coating process. The magnetic force may be chosen to exceed the expected forces by a predetermined safety margin, which may for instance be in a range of additional 5% to 20% of the expected force.

Figure 4 schematically depicts two carrier elements 38 according to another optional embodiment, each having three mounting frames 10 according to another optional embodiment mounted thereto. The carrier elements 38 are adapted as bar-shaped rigid elements, which engage respective lugs formed at the upper end of the mounting frames 10. According to this embodiment, no magnetic element and/or no magnetic fixation element 38 is necessarily required. Instead, the fixation of the mounting frames 10 to the carrier element 38 may be managed solely by mechanical means, such as an interlocking engagement of the mounting frames 10 with the respective carrier element 38. The carrier elements 38 may be attached to or form part of a support frame adapted to be inserted in a lacquer bath such that the spectacle lens products 12 mounted in the fixated mounting frames 10 are entirely immersed into the lacquer bath.

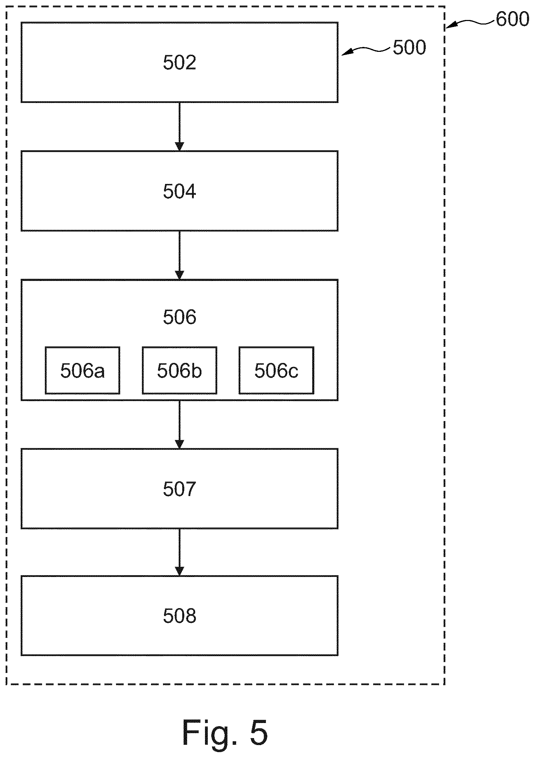

Figure 5 schematically illustrates a method 500 for coating a spectacle lens product according to an optional embodiment.

The method 500 comprises in a step 502 mounting the spectacle lens product in a mounting frame 10, wherein the spectacle lens product 12 is connected to the mounting frame 10 at a connection point at a circumferential edge of the spectacle lens product 12.

The method 500 further comprises in a step 504 applying a hard coating to the spectacle lens product 12, including dip coating the spectacle lens product while the spectacle lens product 12 is mounted in the mounting frame 10. Dip coating the spectacle lens product 12 mounted in the mounting frame 10 may include dip coating the mounting frame 10 at least partially.

The method 500 is characterized in that the method 500 further comprises in a step 506 the application of an anti-reflection coating, AR coating, to the spectacle lens product 12 while the spectacle lens product 12 is mounted in the mounting frame 10. Applying the AR coating to the spectacle lens product may include arranging the spectacle lens product 12 mounted in the mounting frame 10 in a vacuum chamber and evacuating the vacuum chamber with the spectacle lens product and the mounting frame 10 arranged in the vacuum chamber.

Moreover, applying 506 the AR Coating to the spectacle lens product may comprise applying 506a the AR Coating to a first surface of the spectacle lens product 12, flipping 506b the mounting frame 10 with the spectacle lens product 12 mounted therein around a flipping axis 100 of the mounting frame10, and applying 506c the AR coating to a second surface of the spectacle lens product 12. Flipping the mounting frame 10 around the flipping axis 100 of the mounting frame 10 may be carried out inside the evacuated vacuum chamber. The mounting frame 10 may comprise one or more magnetic elements 20, wherein flipping 506b the mounting frame may be carried out at least partially by applying a magnetic force to the one or more magnetic elements 20. Applying 506 the AR coating may include applying an anti-static coating, which may comprise or consist of a coating with indium-tin-oxide (ITO).

Dip coating the spectacle lens product 12 mounted in the mounting frame 10 may comprise attaching the mounting frame 10 to a carrier element 38 by applying a magnetic force to the one or more magnetic elements 20, and moving the carrier element 38 so as to dip the spectacle lens product 12 mounted in the mounting frame 10 into a lacquer bath. Moreover, mounting the spectacle lens product 12 in the mounting frame 10 may comprise attaching a mounting extension 18 to the spectacle lens product 12, and fixating the mounting extension 18 to the mounting frame 10. Attaching the mounting extension 18 to the spectacle lens product 12 may comprise attaching the mounting extension 18 to the spectacle lens product 12 at least partly by an adhesive. Fixating the mounting extension 18 to the mounting frame 10 may comprise mechanically fixating the mounting extension 18 to the mounting frame 10 using one or more clamp elements 16.

The method 500 may further comprise in a step 508 separating the spectacle lens product 12 from the mounting frame 10 after completing applying the hard coating and the AR coating to the spectacle lens product 12.

In the method 500 a mounting frame 10 may optionally be used, which is adapted according to any one of the optional embodiments presented above.

After completing the AR coating process 506 and before separating the spectacle lens product 12 mounted in the mounting frame 10, a clean coating may be applied to the spectacle lens product in a step 507. This may reduce an adhesion of contaminants to the spectacle lens product 12, which may result in an accumulation of dirt on the spectacle lens product.

Moreover, a method 600 for manufacturing a finished spectacle lens product from a spectacle lens product 12 may be provided, wherein the method 600 comprises coating the spectacle lens product 12 using a method 500 as described above.

### List of reference signs

- 10: mounting frame
- 12: spectacle lens product
- 12a: circumferential edge of spectacle lens product
- 14: frame element
- 16: clamp element
- 18: mounting extension
- 20: magnetic element
- 22: void for magnetic element
- 24: counterweight
- 26: void for counter weight
- 28: bearing protrusion
- 30: structural profile of frame element
- 32: recess
- 34: bulgy cross-sectional profile
- 36: tapered cross-sectional profile.
- 38: carrier element
- 40: recess
- 42: spacer
- 44: magnetic fixation element

- 100: flipping axis

- 500: method for coating a spectacle lens product
- 502 - 508: method steps
- 600: method for manufacturing a finished spectacle lens product

## Claims

1. Method (500) for coating a spectacle lens product (12), the method (500) comprising:
- providing (502) the spectacle lens product (12) mounted in a mounting frame (10), wherein the spectacle lens product (12) is connected to the mounting frame (10) at a connection point at a circumferential edge (12a) of the spectacle lens product (12);
- applying (504) a hard coating to the spectacle lens product (12), including dip coating the spectacle lens product (12) while the spectacle lens product (12) is mounted in the mounting frame (10);
**characterized in that** the method further comprises:
- applying (506) an anti-reflection coating, AR coating, to the spectacle lens product (12) while the spectacle lens product (12) is mounted in the mounting frame (10).

2. Method (500) according to claim 1, wherein dip coating the spectacle lens product (12) mounted in the mounting frame (10) includes dip coating the mounting frame (10) at least partially.

3. Method (500) according to any one of the preceding claims, wherein applying (506) the AR coating to the spectacle lens product (12) includes arranging the spectacle lens product (12) mounted in the mounting frame (10) in a vacuum chamber and evacuating the vacuum chamber with the spectacle lens product (12) and the mounting frame (10) arranged in the vacuum chamber.

4. Method (500) according to claim 3, wherein applying (506) the AR Coating to the spectacle lens product (12) comprises:
- applying (506a) the AR Coating to a first surface of the spectacle lens product (12);
- flipping (506b) the mounting frame (10) with the spectacle lens product (12) mounted therein around a flipping axis (100) of the mounting frame (10); and
- applying (506c) the AR coating to a second surface of the spectacle lens product (12).

5. Method (500) according to claim 4, wherein flipping (506b) the mounting frame (10) around the flipping axis (100) of the mounting frame (10) is carried out inside the evacuated vacuum chamber.

6. Method (500) according to claim 4 or 5, wherein the mounting frame (10) comprises one or more magnetic elements (20) and wherein flipping the mounting frame (10) is carried out at least partially by applying a magnetic force to the one or more magnetic elements (20).

7. Method (500) according to claim 6, wherein dip coating the spectacle lens (12) product mounted in the mounting frame (10) comprises:
- attaching the mounting frame (10) to a carrier element (38) by applying a magnetic force to the one or more magnetic elements (20); and
- moving the carrier element (38) and/or a lacquer bath so as to dip the spectacle lens product (12) mounted in the mounting frame (10) into the lacquer bath.

8. Method (500) according to any one of the preceding claims, wherein providing (502) the spectacle lens product (12) mounted in the mounting frame (10) comprises:
- providing a mounting extension (18) attached to the spectacle lens product (12); and
- providing the mounting extension (18) fixated to the mounting frame (10).

9. Method (500) according to claim 8, wherein the mounting extension (18) is attached to the spectacle lens product (12) at least partly by an adhesive and/or wherein the mounting extension (18) is mechanically fixated to the mounting frame (10) by one or more clamp elements (16).

10. Method (500) according to any one of the preceding claims, further comprising:
- separating (508) the spectacle lens product (12) from the mounting frame (10) after completing applying the hard coating and the AR coating to the spectacle lens product (12).

11. Method (600) of manufacturing a finished spectacle lens product from a spectacle lens product (12), the method (600) comprising coating the spectacle lens product (12) using a method (500) according to any one of the preceding claims.

12. Mounting frame (10) suitable for mounting a spectacle lens product (12) in a coating process, the mounting frame (10) comprising:
- a frame element (14) adapted to surround at least partially a circumferential edge (12a) of the spectacle lens product (12) when mounted in the mounting frame (10);
- a mechanical clamp element (16) adapted to mechanically fixate a mounting extension (18) of the spectacle lens product to the frame element (10), when the spectacle lens product (12) is mounted in the mounting frame (10);
**characterized in that**
the frame element (14) is made of a heat-sustainable polymeric material sustaining a temperature of at least 120° C.

13. Mounting frame (10) according to claim 12, further comprising:
- a magnetic element (20) arranged at a first section of the frame element (14), wherein the magnetic element (20) is adapted to allow flipping the mounting frame (10) around a flipping axis (100) by applying a magnetic force to the magnetic element (20).

14. Mounting frame (10) according to claim 12 or 13, further comprising a counterweight element (24) for balancing a weight distribution of the mounting frame (10) with respect to the flipping axis (100).

15. Mounting frame (10) according to claim 13 or 14, wherein the mechanical clamp element (16) is arranged at a second half of the frame element (14) opposing a first half of the frame element (14) including the first section of the frame element (14) including the magnetic element (20).

16. Mounting frame (10) according to any one of claims 12 to 15, further comprising multiple bearing protrusions (28) arranged at opposing sides of the frame element (14) and extending along the flipping axis (100).

17. Mounting frame (10) according to any one of the claims 12 to 16, wherein the polymeric material comprises or consists of polyoxymethylene.
